# EUROPÄISCHE PATENTSCHRIFT

(11) **EP 1 786 255 B1**
(45) Veröffentlichungstag und Bekanntmachung des Hinweises auf die Patenterteilung: **11.01.2012**
(21) Anmeldenummer: 06121203.1
(22) Anmeldetag: 25.09.2006
(51) Int. Cl.: H05K 13/08

(54) **Zuführeinrichtung zum Transport von elektrischen Bauteilen**
Feeding device for transport of electrical components
Dispositif d'alimentation et de transport de composants électriques

(30) Priorität: 14.11.2005 DE 102005054201
(43) Veröffentlichungstag der Anmeldung: 16.05.2007
(73) Patentinhaber: ASM Assembly Systems GmbH & Co. KG, 81379 München (DE)
(72) Erfinder: Hantke, Klaus, 91325, Adelsdorf (DE)
(74) Vertreter: Patentanwälte Bals & Vogel

(56) Entgegenhaltungen:
- JP-A- 3 008 655
- US-A- 5 235 164
- US-A1- 2004 078 962
- US-B1- 6 779 726

## Beschreibung

Die Erfindung betrifft Steuerverfahren zum Steuern einer Zuführeinrichtung, eine Zuführeinrichtung für elektrische Bauteile, ein Bestücksystem und ein Fertigungssystem mit einer derartigen Zuführeinrichtung, sowie ein zugehöriges Fertigungsverfahren.

In einem Bestücksystem zum Bestücken von Substraten mit elektrischen Bauteilen werden die Bauteile meist von so genannten Zuführeinrichtungen bereitgestellt. Die Bauteile sind in geeigneten Vorratsbehältern, beispielsweise Bauteilgurten, gelagert, mit welchen die Zuführeinrichtungen gerüstet werden. Das Einrüsten kann entweder direkt an der Fertigungslinie oder außerhalb der Fertigungslinie auf so genannten Rüstplätzen erfolgen. Insbesondere bei einem Wechsel zwischen zwei aufeinander folgenden unterschiedlichen Bestückaufträgen müssen die Zuführeinrichtungen mit entsprechend anderen Bauteiltypen gerüstet werden. Erfolgt das Einrüsten direkt an der Fertigungslinie, so wird in der Regel eine so genannte Delta-Rüstung durchgeführt, d. h. es werden nur die zur Durchführung des folgenden Bestückauftrags noch zusätzlich benötigten Bauteile nachgerüstet. Der zeitliche Aufwand für die Delta-Rüstung liegt in der Regel bei mehreren Stunden. Während dieser Zeit steht die betroffene Fertigungslinie still. Ist die Anzahl der zu bestückenden Substrate je Bestückauftrag klein, so folgt daraus, dass die Fertigungslinie häufig still steht. Erfolgt das Einrüsten außerhalb der Fertigungslinie, so wird dort während des Betriebs der Fertigungslinie eine komplette zweite Garnitur von Zuführeinrichtungen aufgerüstet, welche bei dem Wechsel auf dem folgenden Bestückauftrag die Garnitur der Zuführeinrichtung des vorherigen, abgeschlossenen Bestückauftrags ersetzt. Im Idealfall kann die Fertigungslinie nun einen Bestückauftrag abarbeiten, während eine Ersatzgarnitur von Zuführeinrichtungen für den folgenden Bestückauftrag gerüstet wird. Das Stoppen der Fertigungslinie ist nur noch nötig, um die Zuführeinrichtungen auszutauschen. Der Austausch der Zuführeinrichtungen benötigt in der Regel nur wenige Minuten. Es ist jedoch zu bedenken, dass das Aufrüsten der Ersatzgarnitur an Zuführeinrichtungen auch mehrere Stunden benötigt. Damit durch die externe Rüstung einer Ersatzgarnitur an Zuführeinrichtungen außerhalb der Fertigungslinie ein Zeitvorteil entsteht, muss folglich die benötigte Fertigungszeit des aktuell durchgeführten Bestückauftrags mindestens so lang sein, wie die zum Einrüsten des folgenden Bestückauftrags benötigte Zeit. Kurze Bestückaufträge verursachen daher stets hohe Maschinenstillstandzeiten, und hohe Material- und Personalkosten

Aus der US 5,235,164 A ist eine Zuführeinrichtung für elektronische Bauelemente offenbart, die einem Bestückautomaten zum Zwecke der automatischen Bestückung von Leiterplatten zugeführt werden sollen. Die Zuführeinrichtung weist zusätzlich zu der üblichen Mechanik einer Bauelement-Zuführvorrichtung eine Steuereinrichtung und eine Anzeigeeinrichtung auf. Die Steuereinrichtung ist derart eingerichtet, dass im Verlauf der Bauelementzuführung die Anzahl an Bauelementen überwacht wird, welche einem Bestückautomat zugeführt werden. Durch eine Erfassung der Anzahl an Bauelementen, welche sich ursprünglich in einem als Bauelement-Vorratsbehälter dienenden sog. Bauelementegurt befinden, ist somit zu jedem Zeitpunkt während des Betriebs der Bauelement-Zuführvorrichtung bekannt, wie viele Bauelemente sich noch in dem Bauelementegurt befinden. Im Falle eines bevorstehenden Ausgehens der Bauelemente kann einer Bedienperson über die Anzeigeeinrichtung ein entsprechender Warnhinweis ausgegeben werden, so dass der inzwischen zumindest nahezu vollständig entleerte Bauelementgurt durch einen neuen mit Bauelementen gefüllten Bauelementgurt ersetzt wird.

Die JP 03 008655 A offenbart eine Bauelement-Zuführeinrichtung, welche eine Steuereinheit und eine Anzeigeeinrichtung aufweist. Mittels der Steuereinheit wird ständig die Anzahl der in einem Bauelement-Vorratsbehälter bzw. in einem Bauelementgurt befindlichen Bauelemente erfasst und basierend auf einer bekannten Zeitdauer für die Zuführung jeweils eines Bauelements eine Restlaufzeit bestimmt, welche angibt, wie lange noch mit dem aktuellen Bauelement-Vorratsbehälter bzw. dem aktuellen Bauelementgurt bestückt werden kann. Die Restlaufzeit wird dann mittels einer Anzeigevorrichtung einer Bedienperson angezeigt.

Die US 6,779,726 B1 offenbart ein Verfahren und eine Vorrichtung zum Steuern von Bestückungsvorgängen, bei denen in einem Bauelementegurt befindliche Bauelemente mittels einer Bauelement-Zuführvorrichtung an einer Entnahmeposition eines Bestückautomaten bereitgestellt werden. Bei der Rüstung der Bauelement-Zuführvorrichtung werden mittels eines elektronischen Lesevorgangs bauelementspezifische Daten sowie die Anzahl der in dem jeweiligen Bauelementgurt befindlichen elektronischen Bauelemente ausgelesen, an eine zentrale Steuereinheit des Bestückungsvorgangs weiter gegeben und bei der Ressourcenplanung des oder der Bestückungsvorgänge berücksichtigt.

Es ist deshalb die Aufgabe der vorliegenden Erfindung, Steuerverfahren zum Steuern einer Zuführeinrichtung, eine zugehörige Zuführeinrichtung, ein Bestücksystem und ein Fertigungssystem mit einer derartigen Zuführeinrichtung und ein zugehöriges Fertigungsverfahren zu liefern, durch welche der Bestückprozess effektiver gestaltet und die Prozesssicherheit bei der rechtzeitigen Zuführung von Bauelementen erhöht werden können.

Diese Aufgabe wird durch, die Steuerverfahren zum Steuern einer Zuführeinrichtung gemäß den Ansprüchen 1 und 2, die Zuführeinrichtung gemäß Anspruch 10, das Bestücksystem gemäß Anspruch 11, das Fertigungssystem gemäß Anspruch 12 und das Fertigungsverfahren gemäß Anspruch 14 gelöst. Vorteilhafte Ausgestaltungen sind Gegenstand der Unteransprüche.

Verfahren zum Steuern einer Zuführeinrichtung zum Zuführen von in einem Vorratsbehälter gelagerten elektrischen Bauteilen sind Gegenstand der Ansprüche 1 bis 9. Aufgrund der Analogie der Verfahrensansprüche und der nachfolgend ausführlich beschriebenen Vorrichtungsansprüche wird an dieser Stelle auf eine detaillierte Darstellung der Verfahren verzichtet und auf die entsprechenden Vorrichtungsansprüche verwiesen. Die Vorteile gelten analog.

Die Zuführeinrichtung gemäß Anspruch 10 weist eine Fördereinrichtung auf, mittels der die in einem Vorratsbehälter gelagerten Bauteile in einer Förderrichtung zu einer Abholposition transportierbar sind, von welcher die Bauteile von einer Handhabungseinrichtung eines der Zuführeinrichtung zugeordneten Bestückautomaten entnehmbar sind. Die Zuführeinrichtung umfasst ferner eine Steuereinrichtung, welche derart ausgebildet ist, dass sie eine aktuelle Anzahl an im Vorratsbehälter gelagerten Bauteilen mit einer Anzahl an Bauteilen, welche bis zur Fertigstellung eines aktuellen Bestückauftrages, bei welchen zumindest ein Substrat mittels des Bestückautomaten bestückt wird, von der Zuführeinrichtung zuzuführen ist, vergleicht. Auf Basis dieses Vergleichs kann die Steuereinrichtung beispielsweise ermitteln, ob die aktuelle Anzahl der im Vorratsbehälter gelagerten Bauteile größer, kleiner oder gleich der Anzahl an Bauteilen ist, welche bis zur Fertigungsstellung des aktuellen Bestückauftrages von der Zuführeinrichtung zuzuführen sind. Durch geeignete Ausbildung der Steuereinrichtung kann diese Information durch entsprechende Mittel nach außen angezeigt oder von einer übergeordneten Steuereinrichtung, beispielsweise einer Zentralsteuerung eines Fertigungssystems, abgerufen werden. Basierend auf dieser Information kann ferner bestimmt werden, ob die Zuführeinrichtung noch vor Abschluss des aktuellen Bestückauftrages durch geeignete Maßnahmen mit Bauteilen für einen auf den aktuellen Bestückauftrag folgenden Bestückauftrag gerüstet werden kann. Dadurch ergäbe sich ein Zeitvorteil beim Umrüsten der Zuführeinrichtung auf den folgenden Bestückauftrag, was den gesamten Bestückprozess effektiver macht.

In einer Ausgestaltung der Zuführeinrichtung sind die Bauteile in der Förderrichtung in einem einheitlichen Abstand in dem Vorratsbehälter angeordnet. Die Fördereinrichtung ist derart ausgebildet, dass die Bauteile in definierten, einheitlichen Transportschritten, bei welchen die Bauteile jeweils um eine einheitliche Vorschubstrecke in Förderrichtung bewegt werden, zu der Abholposition transportierbar sind. Die Steuereinrichtung ist mit der Fördereinrichtung verbunden und derart ausgebildet, dass sie die Anzahl der im Vorratsbehälter gelagerten Bauteile basierend auf einer vorgegebenen Gesamtzahl an Bauteilen des Vorratsbehälters, dem Abstand der Bauteile in dem Vorratsbehälter und der Anzahl der durchgeführten Transportschritte ermittelt. Die Gesamtzahl an Bauteilen des vollen Vorratsbehälters kann beispielsweise in einem Speicherelement der Steuereinrichtung abgespeichert sein oder diesem über eine Datenleitung von außen zugeführt werden. Dadurch, dass die Bauteile in Förderrichtung in einem definierten, einheitlichen Abstand in dem Vorratsbehälter angeordnet sind und die Fördereinrichtung die Bauteile in definierten, einheitlichen Transportschritten transportiert werden, besteht ein fester Zusammenhang zwischen der Anzahl der von der Fördereinrichtung durchgeführten Transportschritte und der Anzahl der Bauteile, welche die Abholposition erreichen und dort, beispielsweise von einem Bestückkopf, dem Vorratsbehälter entnommen werden. Die Steuereinrichtung kann so basierend auf der Anzahl der durchgeführten Transportschritte auf die aktuelle Anzahl der dem Vorratsbehälter entnommenen Bauteile zurückschließen. Dies kann beispielsweise durch Subtraktion der ermittelten Anzahl der entnommenen Bauteile von der vorgegebenen Gesamtzahl an Bauteilen des vollen Vorratsbehälters geschehen. Die erfindungsgemäße Zuführeinrichtung ermöglicht dadurch ein kostengünstige und einfache Ermittlung der aktuellen Anzahl an Bauteilen im Vorratsbehälter.

In einer Ausgestaltung der Zuführeinrichtung ist die Steuereinrichtung derart ausgebildet, dass sie den Vergleich nach jedem Wechsel des Vorratsbehälters durchführt. Dadurch steht das Ergebnis des Vergleichs schon sehr frühzeitig nach Aufnahme eines Bestückauftrages zur Verfügung, so dass beispielsweise der Maschinenbediener frühzeitig geeignete Maßnahmen zur Vorbereitung des folgenden Bestückauftrags ergreifen kann.

Die Zuführeinrichtung kann dahingehend ausgestaltet werden, dass sie mit einer Anzeigeeinrichtung, welche mit der Steuereinrichtung verbunden ist, ausgestattet ist, wobei die Steuereinrichtung derart ausgebildet ist, dass, falls die aktuelle Anzahl der in dem Vorratsbehälter gelagerten Bauteile zumindest so groß wie die Anzahl der bis zur Fertigstellung des aktuellen Bestückauftrags von der Zuführeinrichtung zuzuführenden Bauteile ist, die Steuereinrichtung diese Information mittels der Anzeigeeinrichtung anzeigt. Durch die Anzeigeeinrichtung ist für einen Maschinenbediener leicht erkennbar, ob eine Zuführeinrichtung noch während des Ablaufes eines aktuellen Bestückauftrags mit Bauteilen für einen nachfolgenden Bestückauftrag gerüstet werden kann.

Beim Abholen der Bauteile von dem Vorratsbehälter durch einen Bestückkopf treten Abholfehler, wie beispielsweise der Verlust von Bauteilen, auf. Die Steuereinrichtung ist derart ausgebildet, dass, falls die Summe aus der aktuellen Anzahl der im Vorratsbehälter gelagerten Bauteile und einer vorgegebenen Sicherheitsanzahl zumindest so groß wie die Anzahl der bis zur Fertigstellung des Bestückauftrags zuzuführenden Bauteile ist, die Steuereinrichtung diese Information mittels der Anzeigeeinrichtung anzeigt. Durch die Berücksichtigung der Sicherheitsanzahl werden die auftretenden Abholfehler mitberücksichtigt und es wird sichergestellt, dass die Anzahl der im aktuell geförderten Vorratsbehälter, selbst beim Auftreten von Abholfehlern, zur Fertigstellung des aktuellen Bestückauftrags ausreicht.

Gemäß einer Ausgestaltung der Zuführeinrichtung ist die Zuführeinrichtung über eine Datenschnittstelle mit einer Hauptsteuerung eines Bestückautomaten koppelbar, wobei die Steuereinrichtung derart ausgebildet ist, dass, falls die aktuelle Anzahl der in dem Vorratsbehälter gelagerten Bauteile zumindest so groß ist wie die Anzahl der bis zur Fertigstellung des Bestückauftrags von der Zuführeinrichtung zuzuführenden Bauteile, die Steuereinrichtung diese Information über die Datenschnittstelle an die Hauptsteuerung übermittelt. Dadurch ist die Information, ob die Zuführeinrichtung noch während der Durchführung des aktuellen Bestückauftrags mit Bauteilen für den folgenden Bestückauftrag rüstbar ist, der Hauptsteuerung bekannt und kann basierend darauf entsprechend der Aktionen, wie beispielsweise die Anweisung eines Maschinenbedieners, einleiten. Diese Ausführungsform ist insbesondere dann vorteilhaft, wenn mehrere Zuführeinrichtungen an den Bestückautomaten gekoppelt sind, so dass alle Informationen zentral der Hauptsteuerung zugeführt werden. Dadurch ergeben sich Koordinierungsvorteile.

Analog kann eine Sicherheitsanzahl in die Bildung der Information eingerechnet werden.
Die Steuereinrichtung kann derart ausgebildet sein, dass sie die Sicherheitsanzahl basierend auf einer maximalen Anzahl an tatsächlich benötigten Transportschritten der Fördereinrichtung pro Substrat innerhalb des Bestückauftrags und einer vorgegebenen theoretischen Anzahl an Bauteilen, welche von der Zuführeinrichtung pro Substrat innerhalb des Bestückauftrags zuzuführen sind, berechnet. Wie oben schon erläutert wurde, besteht ein fester Zusammenhang zwischen den von der Fördereinrichtung durchgeführten Transportschritten und der Anzahl der zur Abholposition transportierten Bauteile. Dadurch ist es der Steuereinrichtung möglich, eine maximale Anzahl an zur Bestückung von einem Substrat tatsächlich zugeführten Bauteilen zu bestimmen und diese mit einer vorgegebenen Anzahl an Bauteilen, welche theoretisch zur vollständigen Bestückung eines Substrats nötig wären, zu vergleichen. Aufgrund vorkommender Abholfehler durch den Bestückkopf ist die maximale Anzahl in der Regel größer und im besten Fall genauso groß wie die theoretische Anzahl an Bauteilen. Die Zuführeinrichtung bzw. die Steuereinrichtung berechnet zur Berücksichtigung dieser Abholfehler die Sicherheitsanzahl aus der Differenz der maximalen Anzahl und der theoretischen Anzahl.

Bei einer Ausgestaltung der Zuführeinrichtung kann es sich bei dem Vorratsbehälter um einen ersten oder zweiten Bauteilgurt handeln, in dem die Bauteile in Förderrichtung in einem einheitlichen Abstand gelagert sind. Die Zuführeinrichtung weist ferner einen Hauptfördermechanismus auf, mittels welchem die Bauteile des ersten oder des zweiten Bauteilgurts in einer Förderrichtung zu der Abholposition transportierbar sind. Ferner ist eine Erfassungseinrichtung in Förderrichtung vor der Abholposition vorgesehen, um das Ende des jeweiligen durch den Hauptfördermechanismus transportierten ersten oder zweiten Bauteilgurtes zu erfassen. Die Zuführeinrichtung umfasst ferner einen ersten Hilfsfördermechanismus, um den ersten Bauteilgurt im Anschluss an das Ende des zweiten Bauteilgurts dem Hauptfördermechanismus zuzuführen, falls die Erfassungseinrichtung das Ende des zweiten Bauteilgurts erfasst. Zusätzlich ist ein zweiter Hilfsfördermechanismus vorgesehen, um den zweiten Bauteilgurt im Anschluss an das Ende des ersten Bauteilgurtes dem Hauptfördermechanismus zuzuführen, falls die Erfassungseinrichtung das Ende des ersten Bauteilgurts erfasst. Eine derartige Zuführeinrichtung ist gleichzeitig mit zwei Bauteilgurten rüstbar. Sobald das Ende eines aktuell geförderten bzw. transportierten Bauteilgurtes durch die Erfassungseinrichtung erkannt wird, wird der zweite Bauteilgurt automatisch nachgeführt, so dass ein händisches Nachführen des Bauteilgurtes oder ein Verbinden der Bauteilgurte nicht mehr notwendig ist. Dadurch wird das Zeitfenster zum Nachlegen eines Bauteilgurtes bei Auslaufen eines aktuell geförderten Bauteilgurtes erheblich vergrößert, so dass der Maschinenbediener über ausreichend Zeit zum Nachlegen eines neuen Bauteilgurts verfügt. Dadurch wird auch die Prozesssicherheit des ganzen Bestückvorganges deutlich gesteigert.

Die Zuführeinrichtung kann mit einer Schneideeinrichtung zum Durchtrennen des ersten und zweiten Bauteilgurtes ausgestattet sein, welche in Förderrichtung in einer vorgegebenen Distanz zur Abholposition angeordnet und mit der Steuereinrichtung verbunden ist. Die Steuereinrichtung ist dabei derart ausgebildet, dass sie denjenigen des ersten oder zweiten Bauteilgurtes, welcher von dem Hauptfördermechanismus gefördert wird, mittels der Schneideeinrichtung durchtrennt, wenn die Anzahl der zur Fertigstellung des aktuellen Bestückauftrages von der Zuführeinrichtung zuzuführenden Bauteile gleich oder kleiner der Anzahl der sich zwischen der Schneideeinrichtung und der Abholposition befindlichen Bauteile ist. Der einheitliche Abstand der Bauteile am Bauteilgurt und die Distanz zwischen der Schneideeinrichtung und der Abholposition sind der Steuereinrichtung bekannt. Dadurch kann die Steuereinrichtung basierend auf diesen Daten auf die Anzahl der zwischen der Schneideeinrichtung und der Abholposition befindlichen Bauteile rückschließen. Gleichzeitig ist der Steuereinrichtung die Anzahl der zur Fertigstellung des aktuellen Bestückauftrages von der Zuführeinrichtung zuzuführenden Bauteile bekannt. Sobald die Steuereinrichtung feststellt, dass die Anzahl der Bauteile, welche sich zwischen der Schneideeinrichtung und der Abholposition befinden, zur Fertigstellung des aktuellen Bestückauftrages ausreichen, steuert diese die Schneideeinrichtung derart an, dass der Bauteilgurt durchgeschnitten wird. Wie bezüglich des Anspruchs 9 ausgeführt wurde, wird der jeweils andere Bauteilgurt nachgeführt, nachdem die Erfassungseinrichtung das Ende des aktuell transportierten Bauteilgurtes erfasst hat. Somit wird ein reibungsloser, automatisierter Übergang bei einem Wechsel der Bestückaufträge sichergestellt.

Ferner kann zur Beurteilung, wann die Schneideeinrichtung den Bauteilgurt durchtrennen soll, noch eine Sicherheitsanzahl, welche vorkommende Abholfehler mitberücksichtigt, hinzugezogen werden. Dies erhöht noch zusätzlich die Prozess-Sicherheit.

Bei einer Zuführeinrichtung kann die Steuereinrichtung derart ausgebildet sein, dass sie nach Fertigstellung des aktuellen Bestückauftrages den Bauteilgurt, welcher im Anschluss an das Ende des durchtrennten Bauteilgurtes zugeführt wird, mittels des Hauptfördermechanismus so lange fördert, bis sich das in Förderrichtung erste Bauteil dieses Bauteilgurtes an der Abholposition befindet. Dadurch kann der neue Bestückauftrag in sehr kurzer Zeit und ohne händisches Eingreifen durch den Maschinenbediener nach Beendigung des alten Bestückauftrages gestartet werden.

Das erfindungsgemäße Bestücksystem gemäß Anspruch 11 umfasst einen Bestückautomaten zum Bestücken von Substraten mit elektrischen Bauteilen und zumindest einer an einem Bestückautomaten gekoppelten Zuführeinrichtung nach Anspruch 10. Bezüglich der Vorteile wird auf die vorhergehenden Ausführungen verwiesen, welche auch hier analog gelten.

Ein Fertigungssystem gemäß Anspruch 12 umfasst mindestens ein Bestücksystem, welches zumindest einen Bestückautomaten mit zumindest einer daran gekoppelten Zuführeinrichtung nach Anspruch 10 aufweisen. Das Fertigungssystem umfasst ferner eine Zentralsteuerung, welche mit der Steuereinrichtung der Zuführeinrichtung gekoppelt ist. Die Steuereinrichtung ist derart ausgebildet, dass, falls die aktuelle Anzahl der in dem Vorratsbehälter gelagerten Bauteile zumindest so groß wie die Anzahl der bis zur Fertigstellung des aktuellen Bestückauftrages von der Zuführeinrichtung zuzuführenden Bauteile ist, die Steuereinrichtung diese Information an die Zentralsteuerung übermittelt. Falls die Zuführeinrichtung die Information übermittelt, erkennt die Zentralsteuerung, dass die Zuführeinrichtung vor Beendigung des aktuellen Bestückauftrages mit Bauteilen für einen auf den aktuellen Bestückauftrag folgenden Bestückauftrag rüstbar ist. Falls mehrere Zuführeinrichtungen am Bestückautomat gekoppelt sind, laufen alle Informationen über den aktuellen Bestand an Bauteilen der Zuführeinrichtungen an der Zentralsteuerung des Fertigungssystems zusammen. Dadurch ist es der Zentralsteuerung möglich, zu erkennen, welche Zuführeinrichtung für den folgenden Bestückauftrag noch vor Beendigung des aktuellen Bestückauftrages gerüstet werden können. Somit können entsprechende Maßnahmen von der Zentralsteuerung koordiniert und eingeleitet werden. Diese zentralisierte Koordinierung steigert die Prozesssicherheit erheblich.

In einer Ausgestaltung des Fertigungssystems sind an jedem Bestückautomaten mehrere Zuführeinrichtungen gekoppelt. In der Zentralsteuerung sind fertigungsrelevante Daten von den Bestückaufträgen, welche von dem Bestücksystem durchzuführen sind, gespeichert. Die fertigungsrelevanten Daten umfassen beispielsweise die Anzahl von Bauteilen pro Substrat und pro Bestückauftrag, sowie Informationen über die Typen von Bauteilen, welche zur Durchführung der Bestückaufträge notwendig sind. Die Zentralsteuerung ist derart ausgebildet, dass sie basierend auf den fertigungsrelevanten Daten bestimmt, welche zusätzlichen Arten von Bauteilen zur Durchführung des folgenden Bestückauftrages im Vergleich zum aktuellen Bestückauftrag notwendig sind, und, dass sie diese zusätzlichen Arten von Bauteilen den Zuführeinrichtungen zuordnet, welche vor Beendigung des aktuellen Bestückauftrages mit Bauteilen für den folgenden Bestückauftrag rüstbar sind. Diese Ausgestaltung des Fertigungssystems ermöglicht eine zentrale Zuordnung der für den folgenden Bestückauftrag notwendigen zusätzlichen Bauteile zu den jeweiligen Zuführeinrichtungen, welche schon während des aktuellen Bestückauftrages mit Bauteilen für den Folgebestückauftrag rüstbar sind. Dadurch werden die Prozesssicherheit und auch die Handhabbarkeit durch den Maschinenbediener noch weiter verbessert und vereinfacht.

Ein Fertigungsverfahren für ein Fertigungssystem nach Anspruch 12 ist Gegenstand des Anspruchs 14. Die detaillierten Ausführungen bezüglich der Ansprüche 12 und 13 sind analog auf das Fertigungsverfahren gemäß den Ansprüchen 14, 15 übertragbar und auch die genannten Vorteile gelten analog.

In einer Ausgestaltung des Fertigungsverfahrens nach Anspruch 16 werden die von der Zentralsteuerung erkannten Zuführeinrichtungen vor Beendigung des aktuellen Bestückauftrages mit den jeweils zugeordneten zusätzlichen Arten von Bauteilen gerüstet. Diese Zuführeinrichtung schleusen nach Beendigung des aktuellen Bestückauftrages die restlichen Bauteile für einen beendeten aktuellen Bestückauftrag aus der Zuführeinrichtung aus. Anschließend wird der nachfolgende Bestückauftrag gestartet. Durch dieses Fertigungsverfahren werden die restlichen Bauteile mittels der Fördereinrichtung automatisch aus der Zuführeinrichtung ausgeschleust, ohne dass ein Eingriff durch den Maschinenbediener nötig wird. Gleichzeitig kann der nachfolgende Bestückauftrag mit kurzem Zeitverzug gestartet werden. Dadurch wird die Effektivität des Bestückprozesses weiter verbessert.

Im Folgenden wird die vorliegende Erfindung anhand von Ausführungsbeispielen unter Bezug auf die beigefügten Figuren näher erläutert. In den Figuren sind:
Figur 1 eine schematische Ansicht eines erfindungsgemäßen Fertigungssystems,
Figur 2 eine schematische Ansicht eines ersten Ausführungsbeispiels einer erfindungsgemäßen Zuführeinrichtung,
Figur 3 eine schematische Ansicht eines zweiten Ausführungsbeispiels einer erfindungsgemäßen Zuführeinrichtung.

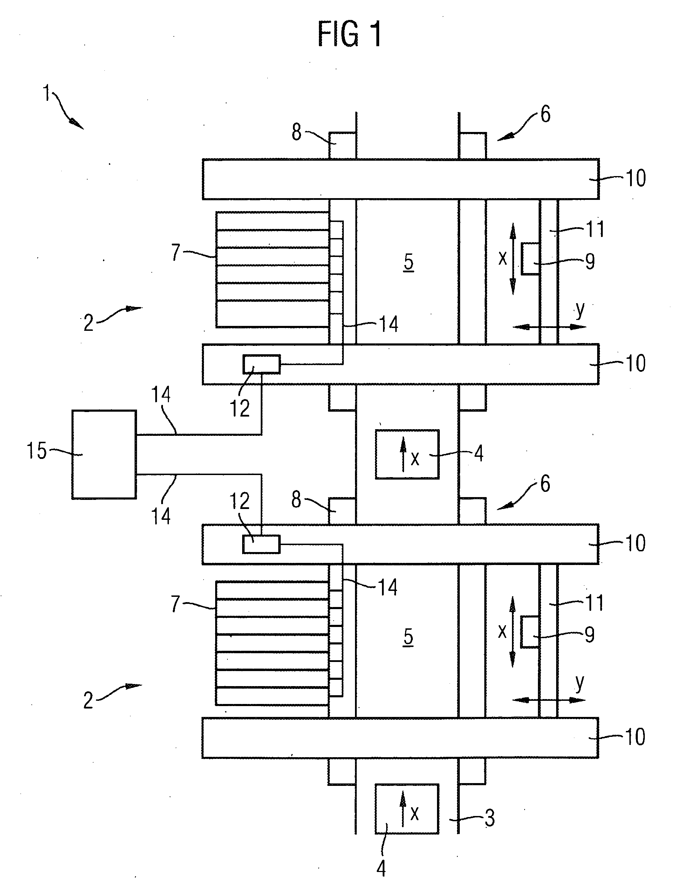

Ein Ausführungsbeispiel des erfindungsgemäßen Fertigungssystems 1 ist in Figur 1 schematisch dargestellt. Das Fertigungssystem 1 umfasst zwei Bestücksysteme 2, welche über eine Transportstrecke 3 für zu bestückende Substrate 4 miteinander verbunden sind. Im Ausführungsbeispiel sind die beiden Bestücksysteme 2 gleichartig ausgebildet, sodass die Beschreibung für beide Bestücksysteme 2 zutrifft. Die zu bestückenden Substrate 4 werden über die Transportstrecke 3 in einer Transportrichtung (Pfeil X) zu Bestückplätzen 5 der Bestücksysteme 2 transportiert, dort bestückt und weiter transportiert. Jedes Bestücksystem 2 weist einen Bestückautomaten 6 und mehrere seitlich der Transportstrecke 3 an die Bestückautomaten 6 gekoppelte Zuführeinrichtungen 7 für elektrische Bauteile. Die Transportstrecke 3 ist dabei über ein Chassis 8 des Bestückautomaten 6 geführt. Jeder Bestückautomat 6 umfasst ferner ein Positioniersystem für einen Bestückkopf 9, welches jeweils aus zwei Trägerbalken 10 besteht, welche die Transportstrecke 3 quer zur Transportrichtung brückenartig überspannen. Das Positioniersystem umfasst ferner einen Trägerarm 11, welcher an beiden Enden quer zur Förderrichtung verschiebbar an den Trägerbalken 10 angebracht ist. An dem Trägerarm 11 selbst ist der Bestückkopf 9 angeordnet, welcher in der Transportrichtung verschiebbar ist. Zum Bestücken der Substrate 4 mit elektrischen Bauteilen wird der Bestückkopf 9 mittels des Positioniersystems zunächst in einen Abholbereich des Bestückautomaten 6, in dem die Zuführeinrichtungen 7 angeordnet sind, verfahren, um dort Bauteile aufzunehmen. Anschließend wird der Bestückkopf 9 zu dem Bestückplatz 5 bewegt, wo das zu bestückende Substrat 4 bereit steht. Das Substrat 4 wird dann durch den Bestückkopf 9 mit elektrischen Bauteilen bestückt.

Der Bestückautomat 6 umfasst ferner eine Hauptsteuerung 12, welche die Vorgänge am Bestückautomat 6 steuert und koordiniert, wie beispielsweise die Bewegungen des Positioniersystems. Jede der Zuführeinrichtungen 7 ist mit einer Steuereinrichtung 13 ausgerüstet, welche die Abläufe in der jeweiligen Zuführeinrichtung 7 koordiniert und steuert. Die Steuereinrichtungen 13 sind jeweils über Datenverbindungen 14 mit der Hauptsteuerung 12 des Bestückautomaten 6 verbunden.

Die Hauptsteuerungen 12 der Bestückautomaten 6, sowie die einzelnen Steuereinrichtungen 13 der Zuführeinrichtungen 7 sind über Datenverbindungen 14 mit einer Zentralsteuerung 15 des Fertigungssystems 1 verbunden, welche die Abläufe an den einzelnen Bestücksystemen 2 koordiniert. Die Zentralsteuerung 15 weist eine Speichereinrichtung (nicht dargestellt) auf, in welcher fertigungsrelevante Daten bezüglich der von dem Fertigungssystem 1 durchzuführenden Bestückaufträge abgespeichert sind. Zu den fertigungsrelevanten Daten zählen beispielsweise die Anzahl und Art der zu bestückenden Substrate 4 je Bestückauftrag, sowie die Anzahl und Art der auf den einzelnen Substraten 4 zu platzierenden Bauteile.

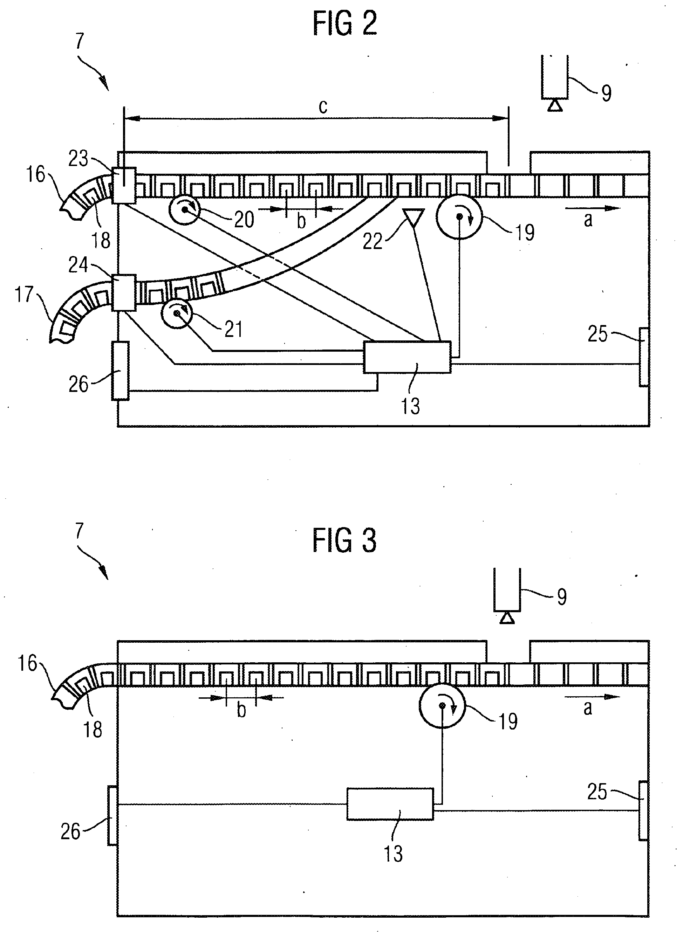

In Figur 2 ist schematisch ein erstes Ausführungsbeispiel einer erfindungsgemäßen Zuführeinrichtung 7 dargestellt. Diese Zuführeinrichtung 7 ist derart ausgebildet, dass sie in einem Bauteilgurt 16, 17 gelagerte Bauteile 18 in einer Förderrichtung (Pfeil a) zu einer Abholposition mittels einer Fördereinrichtung 19 transportiert. Die dabei verwendeten Bauteilgurte 16, 17 weisen taschenartige Vertiefungen auf, in denen die Bauteile 18 in einem definierten und einheitlichen Abstand (b) in Förderrichtung hintereinander angeordnet sind. An der Abholposition werden die Bauteile 18 durch eine Handhabungseinrichtung 9, wie beispielsweise dem Bestückkopf 9 des Bestückautomaten 6, aus den taschenartigen Vertiefungen entnommen.

Im Falle des ersten Ausführungsbeispiels umfasst die Fördereinrichtung 19 einen Hauptfördermechanismus 19, welcher die Bauteilgurte 16, 17 zu der Abholposition befördert. Der Hauptfördermechanismus 19 kann beispielsweise durch ein Transportrad mit radial abstehenden Stiften realisiert werden, die in entsprechenden Perforationen am Bauteilgurt 16, 17 eingreifen. Der Hauptfördermechanismus 19 transportiert die in dem Bauteilgurt 16, 17 befindlichen Bauteile 18 in definierten einheitlichen Transportschritten zu der Abholposition. Aufgrund der einheitlichen und definierten Vorschubstrecke pro Transportschritt und dem einheitlichen und definierten Abstand (b) der Bauteile 18 am Bauteilgurt 16, 17 besteht ein eindeutiger Zusammenhang zwischen der Anzahl der Transportschritte und der Anzahl der zur Abholposition geförderten Bauteile 18 bzw. der Anzahl der dort durch den Bestückkopf 9 entnommenen Bauteile 18. Die Bedeutung dieses eindeutigen Zusammenhangs wird im Verlauf der weiteren Beschreibung deutlich werden.

Die Zuführeinrichtung 7 umfasst des Weiteren einen ersten Hilfsfördermechanismus 20 und einen zweiten Hilfsfördermechanismus 21, welche beide einen ähnlichen Aufbau wie der Hauptfördermechanismus 19 aufweisen. Der erste und der zweite Hilfsfördermechanismus 20, 21 sind so ausgestaltet, dass sie einen ersten Bauteilgurt 16 bzw. einen zweiten Bauteilgurt 17 hintereinander dem Hauptfördermechanismus 19 zuführen.

In Förderrichtung vor der Abholposition ist eine Erfassungseinrichtung 22 so angeordnet, dass sie das Ende des vom dem Hauptfördermechanismus 19 gerade transportierten ersten oder zweiten Bauteilgurts 16, 17 erfasst. In dem in Figur 2 dargestellten Ausführungsbeispiel befindet sich die Erfassungseinrichtung 22 in der Förderrichtung vor dem Hauptfördermechanismus 19. Die Erfassungseinrichtung 22 kann beispielsweise als optischer Sensor, welcher eine Markierung am Ende des Bauteilgurtes 16, 17 erkennt, oder als Durchgangslichtschranke ausgebildet sein.

Die Zuführeinrichtung 7 ist ferner mit einer ersten Schneideeinrichtung 23 und einer zweiten Schneideeinrichtung 24 zum Durchtrennen des ersten bzw. des zweiten Bauteilgurtes 17 ausgestattet. Die erste Schneideeinrichtung 23 und die zweite Schneideeinrichtung 24 sind in Förderrichtung jeweils in einer definierten Distanz (c) zur Abholposition angeordnet.

Wie bezüglich der Figur 1 schon erwähnt wurde, weist die Zuführeinrichtung 7 eine Steuereinrichtung 13 auf, welche die Abläufe innerhalb der Zuführeinrichtung 7 koordiniert und steuert. Dazu ist die Steuereinrichtung 13 mit dem Hauptfördermechanismus 19, dem ersten und zweiten Hilfsfördermechanismus 20, 21, sowie mit der ersten und zweiten Schneideeinrichtung 23, 24 verbunden. In einem Zustand, in dem die Zuführeinrichtung 7 an dem Bestückautomaten 6 gekoppelt ist, ist die Steuereinrichtung 13 über eine entsprechende Datenschnittstelle 22 mit der Hauptsteuerung 12 des Bestückautomaten 6 und der Zentralsteuerung 15 des Fertigungssystems 1 verbunden. Zur Anzeige von Informationen ist an der Zuführeinrichtung 7 zusätzlich eine Anzeigeeinrichtung 26 vorgesehen. Diese ist mit der Steuereinrichtung 13 verbunden, so dass Informationen, beispielsweise für einen Maschinenbediener, von der Steuereinrichtung 13 über diese Anzeigeeinrichtung 26 nach außen ausgegeben werden können.

Im Folgenden wird die Funktionsweise der in Figur 2 dargestellten Zuführeinrichtung 7 näher beschrieben. Zunächst wird die Zuführeinrichtung 7 mit dem ersten und zweiten Bauteilgurt 16, 17 gerüstet. Dazu wird dem ersten Hilfsfördermechanismus 20 der erste Bauteilgurt 16 und dem zweiten Hilfsfördermechanismus 21 der zweite Bauteilgurt 17 zugeführt. Der erste Hilfsfördermechanismus 20 führt dem Hauptfördermechanismus 19 den ersten Bauteilgurt 16 zu. Sobald der erste Bauteilgurt 16 mit dem Hauptfördermechanismus 19 in Eingriff steht, übernimmt der Hauptfördermechanismus 19 den Weitertransport des ersten Bauteilgurtes 16 und der erste Hilfsfördermechanismus 20 wird von der Steuereinrichtung 13 passiv geschaltet. Der Hauptfördermechanismus 19 fördert den ersten Bauteilgurt 16 solange in der Förderrichtung, bis das erste Bauteil 18 an der Abholposition positioniert ist. Bei Aufnahme des Bestückvorganges holt der Bestückkopf 9 die Bauteile 18 aus dem ersten Bauteilgurt 16 ab. Sobald ein Bauteil 18 abgeholt wurde, wird der Hauptfördermechanismus 19 von der Steuereinrichtung 13 derart angesteuert, dass er den ersten Bauteilgurt 16 in Förderrichtung so weiter transportiert, dass das nächste Bauteil 18 zur Abholposition gelangt. Wird das Ende des ersten Bauteilgurtes 16 durch die Erfassungseinrichtung 22 erfasst, steuert die Steuereinrichtung 13 den in Warteposition gehaltenen zweiten Hilfsfördermechanismus 21 derart an, dass dieser den zweiten Bauteilgurt 17 unmittelbar im Anschluss an das Ende des ersten Bauteilgurtes 16 dem Hauptfördermechanismus 19 zuführt. Die Annäherung des zweiten Bauteilgurtes 17 an das Ende des ersten Bauteilgurtes 16 wird von der Erfassungseinrichtung 22 erkannt. Daraufhin synchronisiert die Steuereinrichtung 13 den zweiten Hilfsfördermechanismus 21 mit dem Hauptfördermechanismus 19. Der zweite Bauteilgurt 17 wird dem Hauptfördermechanismus 19 im selben Fördertakt und mit denselben Transportschritten derart zugeführt, dass der Abstand zwischen dem letzten sich auf dem ersten Bauteilgurt 16 befindlichen Bauteil 18 zu dem ersten sich auf dem zweiten Bauteilgurt 17 befindlichen Bauteil 18 gleich dem Abstand der auf dem ersten Bauteilgurt 16 befindlichen Bauteile 18 ist. Dadurch wird gewährleistet, dass selbst an der Übergangsstelle zwischen dem ersten und dem zweiten Bauteilgurt 16, 17 der Abstand zwischen den Bauteilen 18 derselbe ist, wie er bereits auf dem ersten Bauteilgurt 16 vorherrscht. Sobald der erste Bauteilgurt 16 aus dem Hauptfördermechanismus 19 ausläuft, übernimmt der Hauptfördermechanismus 19 den Transport des zweiten Bauteilgurtes 17. Währenddessen kann von einem Maschinenbediener bereits ein neuer Bauteilgurt dem ersten Hilfsfördermechanismus 20 zugeführt werden. Erfasst die Erfassungseinrichtung 22 das Ende des zweiten Bauteilgurtes 17, so wird auch der neue Bauteilgurt analog dem oben beschriebenen Vorgang dem Hauptfördermechanismus 19 zugeführt, so dass der Fördervorgang ohne Unterbrechung weitergeführt werden kann.

Wie oben schon erwähnt wurde, sind in der Zentralsteuerung 15 sämtliche fertigungsrelevanten Daten für die von den Bestücksystemen 2 durchzuführenden Bestückaufträge abgespeichert. Unter diesen fertigungsrelevanten Daten befinden sich auch Informationen über die Art und die Anzahl der von den Zuführeinrichtungen 7 pro Bestückauftrag und pro Substrat 4 zu fördernden Bauteile 18. Diese Informationen können von der Zentralsteuerung 15 an die Steuereinrichtungen 13 der jeweiligen Zuführeinrichtungen 7 übermittelt werden. Dadurch ist jeder Steuereinrichtung 13 die Anzahl an Bauteilen 18 bekannt, welche bis zur Fertigstellung eines aktuellen Bestückauftrages von der Zuführeinrichtung 7 zuzuführen ist. Standardmäßig ist in jedem vollen Bauteilgurt 16, 17 eine bestimmte Gesamtzahl an Bauteilen 18 in einem einheitlichen, definierten Abstand (b) zueinander gelagert. Auch diese Information ist als fertigungsrelevantes Datum in der Zentralsteuerung 15 gespeichert und kann den Steuereinrichtungen 13 der Zuführeinrichtungen 7 übermittelt werden. Dadurch kann die Steuereinrichtung 13 anhand der Anzahl der durch den Hauptfördermechanismus 19 durchgeführten definierten Förderschritte ermitteln, wie viele Bauteile 18 von dem Hauptfördermechanismus 19 zur Abholposition befördert und von dort durch den Bestückkopf 9 abgeholt wurden. Die Steuereinrichtung 13 ist derart ausgebildet, dass sie aus der Differenz aus der vorgegebenen Gesamtzahl an Bauteilen 18 des vollen Bauteilgurtes 16, 17 und der Anzahl der zur Abholposition geförderten und dort abgeholten Bauteile 18 eine aktuelle Anzahl an im Bauteilgurt 16, 17 gelagerten Bauteilen 18 berechnet. Die Steuereinrichtung 13 vergleicht die aktuelle Anzahl der im Bauteilgurt 16, 17 gelagerten Bauteile 18 mit der von der Zentralsteuerung 15 gelieferten Anzahl an Bauteilen 18, welche bis zur Fertigstellung des aktuellen Bestückauftrages von der Zuführeinrichtung 7 zuzuführen sind. Das Ergebnis dieses Vergleichs kann beispielsweise der Zentralsteuerung 15 übermittelt werden. Es ist jedoch auch möglich, dass die Steuereinrichtung 13 das Ergebnis des Vergleichs über die Anzeigeeinrichtung 26 einem Maschinenbediener anzeigt.

Erkennt die Steuereinrichtung 13 aufgrund des Vergleichs, dass die aktuelle Anzahl der im Bauteilgurt 16, 17 gelagerten Bauteile 18 zumindest so groß ist wie die Anzahl der bis zur Fertigstellung des aktuellen Bestückauftrages von der Zuführeinrichtung 7 zuzuführenden Bauteile 18, so übermittelt die Steuereinrichtung 13 diese Information an die Hauptsteuerung 12 des Bestückautomaten 6 oder die Zentralsteuerung 15, oder zeigt dies direkt mittels der Anzeigeeinrichtung 26 an. Basierend auf dieser Information erkennt die Zentralsteuerung 15, dass die Zuführeinrichtung 7, welche die Information übermittelt hat, vor Beendigung des aktuellen Bestückauftrages mit Bauteilen 18 für einen auf den aktuellen Bestückauftrag folgenden Bestückauftrag rüstbar ist. Im Ausführungsbeispiel gemäß Figur 2 wäre dies dadurch möglich, dass während der erste Bauteilgurt 16 zur Durchführung des ersten Bestückauftrages verwendet wird, schon der zweite Bauteilgurt 17, welcher Bauteile 18 für die Durchführung des folgenden Bestückauftrages enthält, dem zweiten Hilfsfördermechanismus 21 zugeführt wird. Ist der aktuelle Bestückauftrag beendet, so steuert die Steuereinrichtung 13 der jeweiligen Zuführeinrichtung 7 den Hauptfördermechanismus 19 derart an, dass dieser die restlichen Bauteile 18 des ersten Bauteilgurtes 16 aus der Zuführeinrichtung 7 ausschleust. Nach Erkennen des Endes des ersten Bauteilgurtes 16 durch die Erfassungseinrichtung 22 steuert die Steuereinrichtung 13 den zweiten Hilfsfördermechanismus 21 derart an, dass der zweite Bauteilgurt 17 für den folgenden Bestückauftrag automatisch dem Hauptfördermechanismus 19 zugeführt wird.

Die Zentralsteuerung 15 bestimmt ferner basierend auf den abgespeicherten fertigungsrelevanten Daten, welche zusätzliche Arten von Bauteilen 18 zur Durchführung des folgenden Bestückauftrages im Vergleich zum aktuellen Bestückauftrag notwendig sind und weist diese zusätzlichen Arten von Bauteilen 18 denjenigen Zuführeinrichtungen 7 zu, welche vor Beendigung des aktuellen Bestückauftrages mit Bauteilen 18 für den folgenden Bestückauftrag gerüstet werden können.

Durch die Erfindung ist es daher möglich, noch während der Durchführung eines aktuellen Bestückauftrages die Zuführeinrichtungen 7 in der Fertigungslinie mit Bauteilen 18 für den folgenden Bestückauftrag zu rüsten. Dadurch werden Zeitverluste, wie sie durch ein Rüsten der Zuführeinrichtungen 7 nach Beendigung eines aktuellen Bestückauftrages auftreten, deutlich verringert werden. Im idealen Fall können während Durchführung des aktuellen Bestückauftrages sämtliche zusätzliche Arten von Bauteilen 18 für den folgenden Bestückauftrag an den Zuführeinrichtungen 7 gerüstet werden. In diesem Fall kann der folgende Bestückauftrag praktisch ohne Unterbrechung nach Fertigstellung des aktuellen Bestückauftrages durchgeführt werden.

Während des Bestückvorganges kann es vorkommen, dass der Bestückkopf 9 das gerade von der Zuführeinrichtung 7 abgeholte Bauteil 18 verliert, oder er dieses in einer derart ungünstigen Lage abholt, dass es nicht verbaut werden kann. Das Bauteil 18 wird dann meist verworfen und der Abholvorgang muss wiederholt werden. Zur Erhöhung der Prozess-Sicherheit berücksichtigt die Steuereinrichtung 13 bei dem von ihr durchgeführten Vergleich eine Sicherheitsanzahl. Falls die Summe der Anzahl der im Bauteilgurt gelagerten Bauteile 18 und dieser Sicherheitsanzahl so groß ist wie die Anzahl der bis zur Fertigstellung des aktuellen Bestückauftrages durch die Zuführeinrichtung 7 zuzuführenden Bauteile 18 ist, so übermittelt die Steuereinrichtung 13 diese Information an die Zentralsteuerung 15 bzw. an die Hauptsteuerung 12. Zur Bestimmung der Abholfehler ermittelt die Steuereinrichtung 13 für jedes Substrat 4 innerhalb des aktuellen Bestückauftrages die Anzahl der tatsächlich benötigten Transportschritte der Fördereinrichtung 19 bzw. die Anzahl der tatsächlich zugeführten Bauteile 18 pro Substrat 4. Davon wird der maximale Wert, d.h. die maximale Anzahl an tatsächlich benötigten Transportschritten bzw. an tatsächlich zugeführten Bauteilen 18 pro Substrat 4, abgespeichert. Gleichzeitig ist der Steuereinrichtung 13 eine theoretische Anzahl an Bauteilen 18, welche von der Zuführeinrichtung 7 pro Substrat 4 innerhalb des aktuellen Bestückauftrages zuzuführen sind, durch die in der Zentralsteuerung 15 abgespeicherten fertigungsrelevanten Daten bekannt. Die Steuereinrichtung 13 ermittelt die Sicherheitsanzahl dadurch, dass sie die theoretische Anzahl an Bauteilen 18, welche von der Zuführeinrichtung 7 pro Substrat 4 zuzuführen sind, von der maximalen Anzahl an tatsächlich zugeführten Bauteilen 18 pro Substrat 4 innerhalb des aktuellen Bestückauftrags abzieht. Dadurch wären die Abholfehler bei der Beurteilung, ob eine Zuführeinrichtung 7 noch während des aktuellen Bestückauftrages mit Bauteilen 18 für den folgenden Bestückauftrag gerüstet werden können, berücksichtigt. Dies erhöht die Prozesssicherheit.

Wie oben schon erwähnt wurde, umfasst die Zuführeinrichtung 7 eine erste Schneideeinrichtung 23 und eine zweite Schneideeinrichtung 24, welche jeweils in einer definierten Distanz (c) zur Abholposition in Förderrichtung vor der Abholposition angeordnet ist. Dadurch, dass auch die Bauteile 18 in einem festen einheitlichen Abstand (b) am ersten und zweiten Bauteilgurt 16, 17 angeordnet sind, ist auch die Anzahl der sich zwischen der ersten Schneideeinrichtung 23 bzw. der zweiten Schneideeinrichtung 24 und der Abholposition befindlichen Bauteile 18 bekannt. Die Steuereinrichtung 13 steuert die erste und zweite Schneideeinrichtung 23, 24 jeweils derart an, dass diese den ersten bzw. zweiten Bauteilgurt 16, 17 durchtrennt, wenn die Anzahl der sich zwischen der ersten bzw. zweiten Schneideeinrichtung 23, 24 und der Abholposition befindlichen Bauteile 18 mindestens genauso groß ist, wie die zur Fertigstellung des aktuellen Bestückauftrages von der Zuführeinrichtung 7 zuzuführen Bauteile 18. Auch dabei kann wiederum die Sicherheitsanzahl mit einberechnet werden.

In dem obigen Ausführungsbeispiel der Zuführeinrichtung 7 können aufgrund des ersten und zweiten Hilfsfördermechanismus 20, 21 gleichzeitig zwei Bauteilgurte 16, 17 an der Zuführeinrichtung 7 gerüstet sein. Die Erfindung ist jedoch auch auf eine Zuführeinrichtung 7 übertragbar, deren Fördereinrichtung 19 nur einen Fördermechanismus aufweist, durch welchen nur ein einzelner Bauteilgurt 16 befördert werden kann. Eine derartige Zuführeinrichtung 7 ist in Figur 3 dargestellt. Die darin abgebildete Zuführeinrichtung 7 unterscheidet sich von der Zuführeinrichtung 7 nach Figur 2 dadurch, dass ihr der erste und zweite Hilfsfördermechanismus 20, 21 sowie die Erfassungseinrichtung 22 und die erste und zweite Schneideeinrichtung 23, 24 fehlen. Bis auf diese Unterschiede ist die Beschreibung bezüglich des Ausführungsbeispiels nach Figur 2 analog übertragbar. Auch wenn im Unterschied zu dem Ausführungsbeispiel gemäß Figur 2 hier nur ein einzelner Bauteilgurt 16 befördert werden kann, kann auch diese Zuführeinrichtung 7 schon während des Durchführung eines aktuellen Bestückauftrages mit einem Bauteilgurt für den folgenden Bestückauftrag gerüstet werden, indem dieser Bauteilgurt an das Ende des aktuell geförderten Bauteilgurt durch geeignete Verbindungsmaßnahmen (Splice) verbunden wird. Hat also die Steuereinrichtung 13 bzw. die Zentralsteuerung 15 erkannt, dass diese Zuführeinrichtung 7 noch während der Durchführung des aktuellen Bestückauftrages schon mit Bauteilen 18 für den darauf folgenden Bestückauftrag gerüstet werden kann und hat die Zentralsteuerung 15 dieser Zuführeinrichtung 7 die entsprechenden Bauteile 18 zugewiesen, so kann dies über geeignete Anzeigeeinrichtungen einem Maschinenbediener mitgeteilt werden. Dieser kann dann den Bauteilgurt, in welchem die Bauteile 18 für den folgenden Bestückauftrag gelagert sind, an den aktuell geförderten Bauteilgurt 16 anheften. Ist der aktuelle Bestückauftrag beendet, so steuert die Steuereinrichtung 13 die Fördereinrichtung 19 bzw. das Transportrad derart an, dass sie die restlichen Bauteile 18 des Bauteilgurtes 16 für den aktuell abgeschlossenen Bestückauftrag ausschleust und soweit transportiert, dass das erste Bauteil 18 des Bauteilgurtes für den folgenden Bestückauftrag an der Abholposition bereitsteht. Somit kann der folgende Bestückauftrag mit nur kurzer Unterbrechung gestartet werden.

Durch die Erfindung ist es möglich, den Zeitverlust aufgrund der Rüstzeiten zwischen zwei aufeinander folgenden Bestückaufträgen erheblich zu reduzieren. Eine so genannte Delta-Rüstung ist in der Fertigungslinie ohne Zeitverzögerung möglich, da diese schon während der Durchführung eines aktuellen Bestückauftrages gemacht werden kann. Eine externe Rüstung, welche material-, zeit- und personalaufwendig ist, ist nicht notwendig. Dadurch können Kosten reduziert und die gesamte Effizienz des Bestückprozesses verbessert werden.

Auch wenn es sich im obigen Ausführungsbeispiel um eine Zuführeinrichtung 7 zum Zuführen von in einem Bauteilgurt gelagerten Bauteilen 18 handelt, so ist doch die Erfindung auch auf andere Arten von Zuführeinrichtungen 7 übertragbar. Als Beispiel wäre zu nennen, dass als Vorratsbehälter nicht ein Bauteilgurt dient, sondern ein längliches Magazin, in dem die Bauteile 18 hintereinander gelagert sind und beispielsweise durch einen mechanischen oder pneumatisch oder elektrisch betätigten Schieber zu einer Abholposition transportiert werden. Ferner ist als Vorratsbehälter auch ein so genannter Tray (Tablett), wie er beispielsweise in einem Tray-Feeder zum Einsatz kommt, denkbar.

### Bezugszeichenliste:

- 1: Fertigungssystem
- 2: Bestücksystem
- 3: Transportstrecke
- 4: Substrat
- 5: Bestückplatz
- 6: Bestückautomat
- 7: Zuführeinrichtung
- 8: Chassis
- 9: Bestückkopf
- 10: Trägerbalken
- 11: Trägerarm
- 12: Hauptsteuerung
- 13: Steuereinrichtung
- 14: Datenverbindung
- 15: Zentralsteuerung
- 16: Erster Bauteilgurt
- 17: Zweiter Bauteilgurt
- 18: Bauteile
- 19: Fördeeinrichtung
- 20: Erster Hilfsfördermechanismus
- 21: Zweiter Hilfsfördermechanismus
- 22: Erfassungseinrichtung
- 23.: Erste Schneideeinrichtung
- 24: Zweite Schneideeinrichtung
- 25: Datenschnittstelle
- 26: Anzeigeeinrichtung

## Patentansprüche

1. Verfahren zum Steuern einer Zuführeinrichtung (7) zum Zuführen von in einem Vorratsbehälter (16, 17) gelagerten elektrischen Bauteilen (18), wobei
eine aktuelle Anzahl an im Vorratsbehälter (16, 17) gelagerten Bauteilen (18) mit einer vorgegebenen Anzahl an Bauteilen (18), welche bis zur Fertigstellung eines Bestückauftrags, bei dem zumindest ein Substrat (4) mittels eines der Zuführeinrichtung (7) zugeordneten Bestückautomats (6) mit den Bauteilen (18) bestückt wird, von der Zuführeinrichtung (7) zuzuführen ist, von einer Steuereinrichtung (13) der Zuführeinrichtung (7) verglichen wird, und
falls die aktuelle Anzahl der in dem Vorratsbehälter (16, 17) gelagerten Bauteile (18) zumindest gleich der Anzahl der bis zur Fertigstellung des Bestückauftrags von der Zuführeinrichtung (7) zuzuführenden Bauteile (18) ist, dies mittels einer mit der Steuereinrichtung (13) verbundenen Anzeigeeinrichtung (26) angezeigt wird, **dadurch gekennzeichnet, dass**
falls die Summe aus der aktuellen Anzahl der im Vorratsbehälter gelagerten Bauteile (18) und einer vorgegebenen Sicherheitsanzahl zumindest genauso groß ist wie die Anzahl der bis zur Fertigstellung des Bestückauftrags von der Zuführeinrichtung (7) zuzuführenden Bauteile (18), dies mittels der Anzeigeeinrichtung (26) anzeigt wird.

2. Verfahren zum Steuern einer Zuführeinrichtung (7) zum Zuführen von in einem Vorratsbehälter (16, 17) gelagerten elektrischen Bauteilen (18), wobei
eine aktuelle Anzahl an im Vorratsbehälter (16, 17) gelagerten Bauteilen (18) mit einer vorgegebenen Anzahl an Bauteilen (18), welche bis zur Fertigstellung eines Bestückauftrags, bei dem zumindest ein Substrat (4) mittels eines der Zuführeinrichtung (7) zugeordneten Bestückautomats (6) mit den Bauteilen (18) bestückt wird, von der Zuführeinrichtung (7) zuzuführen ist, von einer Steuereinrichtung (13) der Zuführeinrichtung (7) verglichen wird, und
falls die aktuelle Anzahl der in dem Vorratsbehälter (16, 17) gelagerten Bauteile (18) zumindest so groß wie die Anzahl der bis zur Fertigstellung des Bestückauftrags von der Zuführeinrichtung (7) zuzuführenden Bauteile (18) ist, die Steuereinrichtung (13) diese Information über eine Datenschnittstelle (22), mittels welcher die Zuführeinrichtung (7) an eine Hauptsteuerung (12) eines Bestückautomaten (6) gekoppelt ist, an die daran gekoppelte Hauptsteuerung (12) übermittelt wird, **dadurch gekennzeichnet, dass**
falls die Summe aus der aktuellen Anzahl der im Vorratsbehälter (16, 17) gelagerten Bauteile (18) und einer vorgegebenen Sicherheitsanzahl zumindest so groß wie die Anzahl der bis zur Fertigstellung des Bestückauftrags zuzuführenden Bauteile (18) ist, diese Information von der Steuereinrichtung (13) über die Datenschnittstelle (22) an die daran gekoppelte Hauptsteuerung (12) übermittelt wird.

3. Verfahren nach Anspruch 1 oder 2, wobei die Bauteile (18) in einer Förderrichtung in einem einheitlichen Abstand (b) auf einem dem Bauteilgurt angeordnet sind und mittels einer Fördereinrichtung (19) in definierten Transportschritten zu einer Abholposition transportiert werden, von welcher die Bauteile (18) von einer Handhabungseinrichtung des Bestückautomats (6) entnommen werden, und wobei die aktuelle Anzahl an im Vorratsbehälter (16, 17) gelagerten Bauteilen (18) basierend auf einer vorgegebenen Gesamtzahl an Bauteilen (18) des vollen Vorratsbehälters, dem Abstand der Bauteile (18) in dem Vorratsbehälter (16, 17) und der Anzahl der durchgeführten Transportschritte durch die Steuereinrichtung (13) ermittelt wird.

4. Verfahren nach einem der Ansprüche 1 bis 3, wobei die Steuereinrichtung (13) den Vergleich nach jedem Wechsel des Vorratsbehälters (16, 17) durchführt.

5. Verfahren nach einem der Ansprüche 1 bis 4, wobei die im Vorratsbehälter (16, 17) gelagerten Bauteile (18) mittels einer Fördereinrichtung (19) in definierten Transportschritten zu einer Abholposition transportiert werden, von welcher die Bauteile (18) von einer Handhabungseinrichtung des Bestückautomats (6) entnommen werden, wobei die Steuereinrichtung (13) die Sicherheitsanzahl basierend auf einer maximalen Anzahl an tatsächlich benötigten Transportschritten der Fördereinrichtung (19) pro Substrat (4) innerhalb des Bestückauftrags und einer vorgegebenen theoretischen Anzahl an Bauteilen (18), welche von der Zuführeinrichtung (7) pro Substrat (4) innerhalb des Bestückauftrags zuzuführen ist, berechnet.

6. Verfahren nach einem der Ansprüche 1 bis 5, wobei der Vorratsbehälter (16, 17) ein erster oder zweiter Bauteilgurt (16, 17) ist und die in dem ersten und im zweiten Bauteilgurt (16, 17) gelagerten Bauteile (18) mittels der Fördereinrichtung (19) der Zuführeinrichtung (7) in definierten Transportschritten zu einer Abholposition transportiert werden, von welcher die Bauteile (18) von einem Bestückkopf (9) entnommen werden, und wobei
- der erste oder zweite Bauteilgurt (16, 17) mittels eines Hauptfördermechanismus (19) der Fördereinrichtung (19) zur Abholposition der Zuführeinrichtung (7) gefördert wird,
- das Ende des jeweiligen durch den Hauptfördermechanismus (19) geförderten ersten oder zweiten Bauteilgurts (16, 17) mittels einer Erfassungseinrichtung (22), welche in Förderrichtung vor der Abholposition vorgesehen ist, erfasst wird,
- der erste Bauteilgurt (16) mittels eines ersten Hilfsfördermechanismus (20) der Fördereinrichtung (19) im Anschluss an das Ende des zweiten Bauteilgurts (17) dem Hauptfördermechanismus (19) zugeführt wird, falls die Erfassungseinrichtung (22) das Ende des zweiten Bauteilgurts (17) erfasst, oder der zweite Bauteilgurt (17) mittels eines zweiten Hilfsfördermechanismus (21) der Fördereinrichtung (19) im Anschluss an das Ende des ersten Bauteilgurts (16) dem Hauptfördermechanismus (19) zugeführt wird, falls die Erfassungseinrichtung (22) das Ende des ersten Bauteilgurts (16) erfasst.

7. Verfahren nach Anspruch 6, wobei der Bauteilgurt (16, 17), welcher von dem Hauptfördermechanismus (19) gefördert wird, mittels einer Schneideeinrichtung (23, 24), welche in Förderrichtung in einer vorgegebenen Distanz (c) zur Abholposition angeordnet und mit der Steuereinrichtung (13) verbunden ist, durchtrennt wird, falls die Anzahl der zur Fertigstellung des aktuellen Bestückauftrags von der Zuführeinrichtung (7) zuzuführenden Bauteile (18) gleich oder kleiner der sich zwischen der Schneideeinrichtung (23, 24) und der Abholposition befindlichen Bauteile (18) ist.

8. Verfahren nach Anspruch 7, wobei der Bauteilgurt (16, 17) dann durchtrennt wird, wenn die Anzahl der zur Fertigstellung des aktuellen Bestückauftrags von der Zuführeinrichtung (7) zuzuführenden Bauteile (18) gleich der Summe aus der Anzahl der sich zwischen der Schneideeinrichtung (23, 24) und der Abholposition befindlichen Bauteile (18) und einer Sicherheitsanzahl ist.

9. Verfahren nach einem der Ansprüche 6 bis 7, wobei nach Fertigstellung des aktuellen Bestückauftrags der im Anschluss an das Ende des durchtrennten Bauteilgurts (16, 17) zugeführte Bauteilgurt (16, 17) mittels des Hauptfördermechanismus (19) solange gefördert wird bis sich das in Förderrichtung erste Bauteil (18) dieses Bauteilgurts (16, 17) an der Abholposition befindet.

10. Zuführeinrichtung (7) zum Zuführen von elektrischen Bauteilen (18), mit
- einer Fördereinrichtung (19), mittels der die in einem Vorratsbehälter (16, 17) gelagerten Bauteile (18) in einer Förderrichtung zu einer Abholposition transportierbar sind, von welcher die Bauteile (18) von einer Handhabungseinrichtung (9) eines der Zuführeinrichtung (7) zugeordneten Bestückautomaten (6) entnehmbar sind, und einer Steuereinrichtung (13), welche derart ausgebildet ist, so dass im Betrieb das Verfahren nach einem der Ansprüche 1 bis 9 ausgeführt wird.

11. Bestücksystem (2) mit einem Bestückautomat (6) zum Bestücken von Substraten (4) mit elektrischen Bauteilen (18) und mindestens einer an den Bestückautomaten (6) gekoppelten Zuführeinrichtung (7) nach Anspruch 10.

12. Fertigungssystem (1) mit
- mindestens einem Bestücksystem (2), welches zumindest einen Bestückautomaten (6) mit zumindest einer daran gekoppelten Zuführeinrichtung (7) nach Anspruch 10 aufweist,
- einer Zentralsteuerung (15), welche mit der Steuereinrichtung (13) der Zuführeinrichtung (7) gekoppelt ist,
- wobei die Steuereinrichtung (13) derart ausgebildet ist, dass, falls die aktuelle Anzahl der in dem jeweiligen Vorratsbehälter (16, 17) gelagerten Bauteile (18) zumindest so groß wie die Anzahl der bis zur Fertigstellung eines aktuellen Bestückauftrags von der Zuführeinrichtung (7) zuzuführenden Bauteile (18) ist, die Steuereinrichtung (13) diese Information an die Zentralsteuerung (15) übermittelt, und
- wobei die Zentralsteuerung (15) derart ausgebildet ist, dass sie erkennt, dass die Zuführeinrichtungen (7) vor Beendigung des aktuellen Bestückauftrags mit Bauteilen (18) für einen auf den aktuellen Bestückauftrag folgenden Bestückauftrag rüstbar ist, falls die Zuführeinrichtung (7) die Information übermittelt.

13. Fertigungssystem (1) nach Anspruch 12, wobei
- eine Vielzahl von Zuführeinrichtungen (7) an jedem Bestautomaten gekoppelt sind,
- in der Zentralsteuerung (15) fertigungsrelevante Daten von den Bestückaufträgen, welche von dem Bestücksystem (2) durchzuführen sind, gespeichert sind, und
- wobei die Zentralsteuerung (15) derart ausgebildet ist, dass sie basierend auf den fertigungsrelevanten Daten bestimmt, welche zusätzlichen Arten von Bauteilen (18) zur Durchführung des folgenden Bestückauftrags im Vergleich zum aktuellen Bestückauftrag notwendig sind, und dass sie diese zusätzlichen Arten von Bauteilen (18) den Zuführeinrichtungen (7) zuordnet, welche vor Beendigung des aktuellen Bestückauftrags mit Bauteilen (18) für den folgenden Bestückauftrag rüstbar sind.

14. Fertigungsverfahren mit einen Fertigungssystem (1) nach Anspruch 13, wobei
- zumindest eine Steuereinrichtung (13) die Information, dass die aktuelle Anzahl der in dem Vorratsbehälter (16, 17) gelagerten Bauteile (18) zumindest so groß wie die Anzahl der bis zur Fertigstellung des aktuellen Bestückauftrags von der Zuführeinrichtung (7) zuzuführenden Bauteile (18) ist, an die Zentralsteuerung (15) übermittelt,
- die Zentralsteuerung (15) die Zuführeinrichtungen (7), welche die Information übermitteln, als Zuführeinrichtungen (7) erkennt, welche vor Beendigung des aktuellen Bestückauftrags mit Bauteilen (18) für den auf den aktuellen Bestückauftrag folgenden Bestückauftrag rüstbar sind.

15. Fertigungsverfahren nach Anspruch 14, wobei
- die Zentralsteuerung (15) die zusätzliche Arten von Bauteilen (18) bestimmt, welche zur Durchführung des folgenden Bestückauftrags im Vergleich zum aktuellen Bestückauftrag notwendig sind, und
- die Zentralsteuerung (15) diese zusätzlichen Arten von Bauteilen (18) den Zuführeinrichtungen (7), welche vor Beendigung des aktuellen Bestückauftrags mit Bauteilen (18) für den auf den aktuellen Bestückauftrag folgenden Bestückauftrag rüstbar sind, zuordnet.

16. Fertigungsverfahren nach Anspruch 15, wobei
- die von der Zentralsteuerung (15) erkannten Zuführeinrichtungen (7) vor Beendigung des aktuellen Bestückauftrags mit den jeweils zugeordneten zusätzlichen Arten von Bauteilen (18) gerüstet werden,
- diese Zuführeinrichtungen (7) nach Beendigung des aktuellen Bestückauftrags die restlichen Bauteile (18) für den beendeten aktuellen Bestückauftrag aus der Zuführeinrichtung (7) ausschleust, und
- der nachfolgende Bestückauftrag gestartet wird.

## Claims

1. A method of controlling a feed device (7) for feeding electrical components (18) stored in a storage container (16, 17), wherein a current number of components (18) stored in the storage container (16, 17) is compared by a control device (13) of the feed device (7) with a pre-set number of components (18) which are to be fed by the feed device (7) until the completion of a fitting order in which at least one substrate (4) is fitted with the components (18) by means of an mounting machine (6) associated with the feed device (7), and
if the current number of the components (18) stored in the storage container (16, 17) is at least equal to the number of the components (18) which are to be fed by the feed device (7) until the completion of the fitting order, this is displayed by means of a display device (26) connected to the control device (13),
**characterized in that**, if the sum of the current number of the components (18) stored in the storage container and of a pre-set safety number is at least as great as the number of the components (18) which are to be fed by the feed device (7) until the completion of the fitting order, this is displayed by means of the display device (26).

2. A method of controlling a feed device (7) for feeding electrical components (18) stored in a storage container (16, 17), wherein a current number of components (18) stored in the storage container (16, 17) is compared by a control device (13) of the feed device (7) with a pre-set number of components (18) which are to be fed by the feed device (7) until the completion of a fitting order in which at least one substrate (4) is fitted with the components (18) by means of an mounting machine (6) associated with the feed device (7), and
if the current number of the components (18) stored in the storage container (16, 17) is at least as great as the number of the components (18) which are to be fed by the feed device (7) until the completion of the fitting order, this information is transmitted by the control device (13) by way of a data interface (22), by means of which the feed device (7) is coupled to a main control device (12) of an mounting machine (6), to the main control device (12) coupled thereto,
**characterized in that**, if the sum of the current number of the components (18) stored in the storage container (16, 17) and of a pre-set safety number is at least as great as the number of the components (18) which are to be fed until the completion of the fitting order, this Information is transmitted by the control device (13) by way of the data interface (22) to the main control device (12), coupled thereto.

3. A method according to Claim 1 or 2, wherein the components (18) are arranged at a uniform distance (b) in the conveying direction on a component belt and are conveyed by means of a conveying device (19) in defined conveying steps to a collection position from which the components (18) are removed by a handling device of the mounting machine (6), and wherein the current number of components (18) stored in the storage container (16, 17) is determined on the basis of a pre-set total number of components (18) of the full storage container, the distance of the components (18) in the storage contalner (16, 17) and the number of the conveying steps carried out through the control device (13).

4. A method according to any one of Claims 1 to 3, wherein the control device (13) performs the comparison after each change of the storage container (16, 17).

5. A method according to any one of Claims to 4, wherein the components (18) stored in the storage container (16, 17) are conveyed by means of a conveying device (19) in defined conveying steps to a collection position from which the components (18) are removed by a handling device of the mounting machine (6), wherein the control device (13) calculates the safety number on the basis of a maximum number of actually required conveying steps of the conveying device (19) per substrate (4) within the fitting order and a pre-set theoretical number of components (18) which is to be fed by the feed device (7) per substrate (4) within the fitting order.

6. A method according to any one of Claims to 5, wherein the storage container (16, 17) is a first or second component belt (16, 17) and the components (18) stored in the first and in the second component belt (16, 17) are conveyed by means of the conveying device (19) of the feed device (7) in defined conveying steps to a collection position from which the components (18) are removed by a mounting head (9), and wherein
- the first or second component belt (16, 17) is conveyed by means of a main conveying mechanism (19) of the conveying device (19) to the collection position of the feed device (7),
- the end of the respective first or second component belt (16, 17) conveyed by the main conveying mechanism (19) is detected by means of a detection device (22) which is provided upstream, of the collection position in the conveying direction,
- the first component belt (16) is fed by means of a first auxiliary conveying mechanism (20) of the conveying device (19) following the end of the second component belt (17) to the main conveying mechanism (19) if the detection device (22) detects the end of the second component belt (17), or the second component belt (17) is fed by means of a second auxiliary conveying mechanism (21) of the conveying device (19) following the end of the first component belt (18) to the main conveying mechanism (19) if the detection device (22) detects the end of the first component belt (16).

7. A method according to Claim 6, wherein the component belt (16, 17) which is conveyed by the main conveying mechanism (19) is severed by means of a cutting device (23, 24) which is arranged at a pre-set distance (c) from the collection position in the conveying direction and which is connected to the control device (13), if the number of the components (18) which are to be fed by the feed device (7) for the completion of the current fitting order is equal to or smaller than the components (18) present between the cutting device (23, 24) and the collection position.

8. A method according to Claim 7, wherein the component belt (16, 17) is severed when the number of the components (18) which are to be fed by the feed device (7) for the completion of the current fitting order is equal to the sum of the number of the components (18) present between the cutting device (23, 24) and the collection, position and a safety number.

9. A method according to any one of Claims 6 to 7, wherein after the completion of the current fitting order the component belt (16, 17) supplied following the end of the severed component belt (16, 17) is conveyed by means of the main conveying mechanism (19) until the first component (18) of this component belt (16, 17) in the conveying direction is present at the collection position.

10. A feed device (7) for feeding electrical components (18), with
- a conveying device (19) by means of which the components (18) stored in a storage container (16, 17) are capable of being conveyed in a conveying direction to a collection position from which the components (18) are capable of being removed by a handling device of an mounting machine (6) associated with the feed device (7), and a control device (13) which is designed in such a way that in operation the method is performed according to any one of Claims 1 to 9.

11. A fitting system (2) with an mounting machine (6) for fitting substrates (4) with electrical components (18) and at least one feed device (7) according to Claim 10 coupled to the mounting machine (6).

12. A production system (1) with
- at least one fitting system (2) which has at least one mounting machine (6) with at least one feed device (7) according to Claim 10 coupled to it,
- a central control means (15) which is coupled to the control device (13) of the feed device (7),
- wherein the control device (13) is designed in such a way that, if the current number of the components (18) stored in the respective storage container (1B, 17) is at least as great as the number of the components (18) to be fed by the feed device (7) until the completion of a current fitting order, the control device (13) transmits this information to the central control means (15), and
- wherein the central control means (15) is designed in such a way that it recognizes that before the termination, of the current fitting order the feed devices (7) are capable of being equipped for a fitting order following the current fitting order, if the feed device (7) transmits the information.

13. A production system (1) according to Claim 12, wherein
- a plurality of feed devices (7) are coupled to each mounting machine,
- data relevant to the production from the fitting orders which are to be executed by the fitting system (2) are stored in the central control means (15), and
- wherein the central control means (15) is designed in such a way that it determines on the basis of the data relevant to the production which additional types of components (18) are necessary for executing the following fitting order as compared with the current fitting order, and that it correlates these additional types of components (18) with the feed devices (7) which before the completion of the current fitting order are capable of being equipped with components (18) for the following fitting order.

14. A production method with a production system (1) according to Claim 13, wherein
- at least one control device (13) transmits to the central control means (15) the information that the current number of the components (18) stored in the storage container (16, 17) is at least as great as the number of the components (18) to be fed by the feed devices (7) until the completion of the current fitting order,
- the central control means (15) recognizes the feed devices (7) which transmit the information as feed devices (7) which before the termination of the current fitting order are capable of being equipped with components (18) for the fitting order following the current fitting order.

15. A production method according to Claim 14, wherein
- the central control means (15) determines the additional types of components (18) which are necessary for executing the following fitting order as compared with the current fitting order, and
- the central control means (15) correlates these additional types of components (18) with the feed devices (7) which before the termination of the current fitting order are capable of being equipped with components (18) for the fitting order following the current fitting order.

16. A production method according to Claim 15, wherein
- before the termination of the current fitting order the feed devices (7) recognized by the central control device (15) are equipped with the additional types of components (18) correlated in each case,
- after the termination of the current fitting order these feed devices (7) sort the remaining components (18) for the terminate current fitting order out of the feed device (7), and
- the following fitting order is started.

## Revendications

1. Procédé de commande d'un dispositif d'alimentation (7) destiné à acheminer des composants électriques (18) entreposés dans un récipient de stockage (16, 17), sachant
qu'un nombre actuel de composants (18) entreposés dans le récipient de stockage (16, 17) est, par un dispositif de commande (13) du dispositif d'alimentation (7), comparé à un nombre prédéfini de composants (18) qui doit être acheminé par le dispositif d'alimentation (7) jusqu'à l'achèvement d'une tâche d'équipement selon laquelle au moins un substrat (4) est équipé des composants (18) au moyen d'un automate d'équipement (6) associé au dispositif d'alimentation (7),
et que, si le nombre actuel de composants (18) entreposés dans le récipient de stockage (16, 17) est au moins égal au nombre de composants (18) à acheminer par le dispositif d'alimentation (7) jusqu'à l'achèvement de la tâche d'équipement, cela est affiché au moyen d'un dispositif d'affichage (26) relié au dispositif de commande (13),
**caractérisé en ce que**, si la somme du nombre actuel de composants (18) entreposés dans le récipient de stockage et d'un nombre de sécurité prédéfini est au moins exactement égale au nombre de composants (18) à acheminer par le dispositif d'alimentation (7) jusqu'à l'achèvement de la tâche d'équipement, cela est affiché au moyen du dispositif d'affichage (26).

2. Procédé de commande d'un dispositif d'alimentation (7) destiné à acheminer des composants électriques (18) entreposés dans un récipient de stockage (16, 17), sachant
qu'un nombre actuel de composants (18) entreposés dans le récipient de stockage (16, 17) est, par un dispositif de commande (13) du dispositif d'alimentation (7), comparé à un nombre prédéfini de composants (18) qui doit être acheminé par le dispositif d'alimentation (7) jusqu'à l'achèvement d'une tâche d'équipement selon laquelle au moins un substrat (4) est équipé des composants (18) au moyen d'un automate d'équipement (6) associé au dispositif d'alimentation (7),
et que, si le nombre actuel de composants (18) entreposés dans le récipient de stockage (16, 17) est au moins égal au nombre de composants (18) à acheminer par le dispositif d'alimentation (7) jusqu'à l'achèvement de la tâche d'équipement, le dispositif de commande (13), via une interface de données (22) au moyen de laquelle le dispositif d'alimentation (7) est accouplé à une commande principale (12) d'un automate d'équipement (6), transmet cette information à la commande principale accouplée (12),
**caractérisé en ce que**, si la somme du hombre actuel de composants (18) entreposés dans le récipient de stockage (16, 17) et d'un nombre de sécurité prédéfini est au moins égale au nombre de composants (18) à acheminer jusqu'à l'achèvement de la tâche d'équipement, cette information est transmise par le dispositif de commande (13), via l'interface de données (22), à la commande principale accouplée (12).

3. Procédé selon la revendication 1 ou 2, sachant que les composants (18) sont disposés dans une direction de transport avec un espacement uniforme (b) sur une courroie porte-composants et sont, au moyen d'un dispositif de transport (19), transportés par étapes de transport définies jusqu'à une position d'enlèvement d'où les composants (18) sont prélevés par un dispositif de manipulation de l'automate d'équipement (6), et sachant que le nombre actuel de composants (18) entreposés dans le récipient de stockage (16, 17) est déterminé sur la base d'un nombre total prédéfini de composants (18) du récipient de stockage plein, de l'espacement des composants (18) dans le récipient de stockage (16, 17) et du nombre d'étapes de transport effectuées par le dispositif de commande (13).

4. Procédé selon l'une des revendications 1 à 3, sachant que le dispositif de commande (13) effectue la comparaison après chaque remplacement du récipient de stockage (16, 17).

5. Procédé selon l'une des revendications 1 à 4, sachant que les composants (18) entreposés dans le récipient de stockage (16, 17) sont, au moyen d'un dispositif de transport (19), transportés par étapes de transport définies jusqu'à une position d'enlèvement d'où les composants (18) sont prélevés par un dispositif de manipulation de l'automate d'équipement (6), sachant que le dispositif de commande (13) calcule le nombre de sécurité sur la base d'un nombre maximal d'étapes de transport du dispositif de transport (19) effectivement nécessaires pour chaque substrat (4) dans la tâche d'équipement, et d'un nombre théorique prédéfini de composants (18) qui doit être apporté par le dispositif d'alimentation (7) pour chaque substrat (4) dans la tâche d'équipement.

6. Procédé selon l'une des revendications 1 à 5, sachant que le récipient de stockage (16, 17) est une première ou une deuxième courroie porte-composants (16, 17) et les composants (18) entreposés dans la première et dans la deuxième courroies porte-composants (16, 17) sont, au moyen du dispositif de transport (19) du dispositif d'alimentation (7), transportés par étapes définies jusqu'à une position d'enlèvement d'où les composants (18) sont prélevés par une tête d'équipement (9), et sachant que
- la première ou la deuxième courroie porte-composants (16, 17) est transportée jusqu'à la position d'enlèvement du dispositif d'alimentation (7) au moyen d'un mécanisme de transport principal (19) du dispositif de transport (19),
- la fin de la première ou deuxième, courroie porte-composants (16, 17) respectivement transportée par le mécanisme de transport principal (19) est détectée au moyen d'un dispositif de détection (22) qui est prévu avant la position d'enlèvement dans la direction de transport,
- la première courroie porte-composants (16) est, au moyen d'un premier mécanisme de transport auxiliaire du dispositif de transport (19), apportée au mécanisme de transport principal (19) à la suite de la fin de la deuxième courroie porte-composants (17) si le dispositif de détection (22) détecte la fin de la deuxième courroie porte-composants (17), ou bien la deuxième courroie porte-composants (17) est, au moyen d'un deuxième mécanisme de transport auxiliaire (21) du dispositif de transport (19), apportée au mécanisme de transport principal (19) à la suite de la fin de la première courroie porte-composants (16) si le dispositif de détection (22) détecte fin de la première courroie porte-composants (16).

7. Procédé selon la revendication 6, sachant que la courroie porte-composants (16, 17) transportée par le mécanisme principal de transport (19) est, au moyen d'un dispositif de coupe (23, 24) disposés à une distance prédéfinie (c) de la position d'enlèvement dans la direction de transport et relié au dispositif de commande (13), sectionnée si le nombre de composants (18) à acheminer par le dispositif d'alimentation (7) pour achever la tâche d'équipement actuelle est inférieur ou égal au nombre de composants (18) se trouvant entre le dispositif de coupe (23, 24) et la position d'enlèvement.

8. Procédé selon la revendication 7, sachant que la courroie porte-composants (16, 17) est sectionnée si le nombre de composants (18) à acheminer par le dispositif d'alimentation (7) pour achever la tâche d'équipement actuelle est égal à la somme du nombre de composants (18) se trouvant entre le dispositif de coupe (23, 24) et la position d'enlèvement et d'un nombre de sécurité.

9. Procédé selon l'une des revendications 6 à 7, sachant qu'à l'achèvement de la tâche d'équipement actuelle, la corroie porte-composants (16, 17) acheminée à la suite de la fin de la courroie porte-composants sectionnée (16, 17) est, au moyen du mécanisme de transport principal (19), transportée jusqu'à ce que le premier composant (18), dans la direction de transport, de cette courroie porte-composants (16, 17) se trouve à la position d'enlèvement.

10. Dispositif d'alimentation (7) pour acheminer des composants électriques (18), comportant
- un dispositif de transport (19) au moyen duquel les composants (18) entreposés dans un récipient de stockage (16, 17) peuvent être transportés dans une direction de transport jusqu'à une position d'enlèvement d'où les composants (18) peuvent être prélevés par un dispositif de manipulation (9) d'un automate d'équipement (6) associé au dispositif d'alimentation (7),
- et un dispositif de commande (13), qui est conçu de telle sorte qu'en fonctionnement, le procédé selon l'une des revendications 1 à 9 est exécuté.

11. Système d'équipement (2), comportant un automate d'équipement (6) pour équiper de composants électriques (18) des substrats (4) et comportant au moins un dispositif d'alimentation (7) selon la revendication 10 accouplé à l'automate d'équipement (6).

12. Système de fabrication (1), comportant
- au moins un système d'équipement (2), qui comporte au moins un automate d'équipement (6) auquel est accouplé au moins un dispositif d'alimentation (7) selon la revendication 10,
- une commande centrale (15), qui est accouplée au dispositif de commande (13) du dispositif d'alimentation (7),
- sachant que le dispositif de commande (13) est conçu de telle sorte que, si le nombre actuel de composants (18) entreposés dans le récipient de stockage respectif (16, 17) est au moins égal au nombre de composants (18) à acheminer par le dispositif d'alimentation (7) jusqu'à l'achèvement d'une tâche d'équipement actuelle, le dispositif de commande (13) transmet cette information à la commande centrale (15),
- et sachant que la commande centrale (15) est conçue de telle sorte qu'elle identifie que le dispositif d'alimentation (7) peut, avant l'achèvement de la tâche d'équipement actuelle, être chargé de composants (18) pour une tâche d'équipement consécutive à la tâche d'équipement actuelle, si le dispositif d'alimentation (7) transmet l'information. "

13. Système de fabrication (1) selon la revendication 12, sachant que
- une pluralité de dispositifs d'alimentation (7) sont accouplés à chaque automate d'équipement,
- des donnés, pertinentes pour la fabrication, des tâches d'équipement qui doivent être effectuées par le système d'équipement (2) sont mémorisées dans la commande centrale (15),
- et la commande centrale (15) est conçue de telle sorte qu'elle détermine, sur la base des données pertinentes pour la fabrication, les types supplémentaires de composants (18) qui sont nécessaires par rapport à la tâche d'équipement actuelle pour exécuter la tâche d'équipement suivante, et qu'elle associe ces types supplémentaires de composants (18) aux dispositifs d'alimentation (7) qui peuvent être chargés, avant l'achèvement de la tâche d'équipement actuelle, de composants (18) pour la tâche d'équipement suivante.

14. Procédé de fabrication avec un système de fabrication (1) selon la revendication 13, sachant que
- au moins un dispositif de commande (13) transmet à la commande centrale (15) l'information consistant en ce que le nombre actuel de composants (18) entreposés dans le récipient de stockage (16, 17) est au moins égal au nombre de composants (18) à acheminer par le dispositif d'alimentation (7) jusqu'à l'achèvement de la tâche d'équipement actuelle,
- la commande centrale (15) identifie les dispositifs d'alimentation (7) qui transmettent l'information comme dispositifs d'alimentation (7) qui peuvent, avant l'achèvement de la tâche d'équipement actuelle, être chargés de composants (18) pour la tâche d'équipement consécutive à la tâche d'équipement actuelle.

15. Procédé de fabrication selon la revendication 14, sachant que
- la commande centrale (15) détermine les types supplémentaires de composants (18) qui sont nécessaires par rapport à la tâche d'équipement actuelle pour exécuter la tâche d'équipement suivante,
- et la commande centrale (15) associe ces types supplémentaires de composants (18) aux dispositifs d'alimentation (7) qui peuvent être chargés, avant l'achèvement de la tâche d'équipement actuelle, de composants (18) pour la tâche d'équipement consécutive à la tâche d'équipement actuelle.

16. Procédé de fabrication selon la revendication 15, sachant que
- les dispositifs d'alimentation (7) identifiés par la commande centrale (15) sont chargés, avant l'achèvement de la tâche d'équipement actuelle, des types supplémentaires respectivement associés de composants (18),
- ces dispositifs d'alimentation (7), une fois achevée la tâche d'équipement actuelle, évacuent du dispositif d'alimentation (7) les composants restants (18) de la tâche d'équipement actuelle achevée,
- et la tâche d'équipement suivante est démarrée.
